# EUROPÄISCHE PATENTSCHRIFT

(11) **EP 2 130 225 B1**
(45) Veröffentlichungstag und Bekanntmachung des Hinweises auf die Patenterteilung: **28.11.2018**
(21) Anmeldenummer: 08715525.5
(22) Anmeldetag: 29.02.2008
(51) Int. Cl.: H01L 25/075, H01L 33/44, H01L 33/62, H01L 33/50

(54) **LICHT EMITTIERENDES MODUL**
LIGHT EMITTING MODULE
MODULE ÉMETTEUR DE LUMIÈRE

(30) Priorität: 07.03.2007 DE 102007011123
(43) Veröffentlichungstag der Anmeldung: 09.12.2009
(73) Patentinhaber: OSRAM Opto Semiconductors GmbH, 93055 Regensburg (DE)
(72) Erfinder: MARFELD, Jan, 93055 Regensburg (DE); WEGLEITER, Walter, 93152 Nittendorf (DE); ENGL, Moritz, 93055 Regensburg (DE)
(74) Vertreter: Epping - Hermann - Fischer
(86) Internationale Anmeldenummer: PCT/DE2008/000363
(87) Internationale Veröffentlichungsnummer: WO 2008/106941

(56) Entgegenhaltungen:
- WO-A-2006/034671
- DE-A1- 3 129 967
- DE-A1- 10 353 679
- JP-A- 9 092 885
- JP-A- 60 253 286

## Beschreibung

Die Erfindung betrifft ein Licht emittierendes Modul, aufweisend ein Trägerelement, eine Mehrzahl von auf dem Trägerelement angeordneten opto-elektronischen Halbleiterbauelementen zum Erzeugen elektromagnetischer Strahlung und eine metallische Anschlussschicht, über die die opto-elektronischen Halbleiterbauelemente mit einer Betriebsspannung versorgt werden.

Ein Licht emittierendes Modul der oben genannten Art ist beispielsweise aus der deutschen Patentanmeldung DE 10 2005 019375 A1 bekannt. Solche Module mit opto-elektronischen Halbleiterbauelementen werden in einer Vielzahl von Anwendungen eingesetzt. Im Vergleich zu herkömmlichen Beleuchtungsmitteln wie etwa Glühlampen weisen sie eine höhere Lebensdauer und einen besseren Wirkungsgrad auf. Beispielsweise ist es bekannt, Module mit besonders leistungsfähigen LED-Bauelementen als Frontscheinwerfer in einem Kraftfahrzeug einzusetzen. Aber auch als lichtstarke Anzeigeelemente finden solche Licht emittierenden Module Verwendung.

DE 103 53 679 A1 (SIEMENS AG [DE]; OSRAM OPTO SEMICONDUCTORS GMBH [DE]; 2. Juni 2005) offenbart ein Licht emittierendes Modul gemäß dem Oberbegriff des Anspruchs 1.

Ein Problem bekannter Licht emittierender Module ist es, das so genannte Nebenleuchten oder auch optische Übersprechen zu begrenzen. Unter Nebenleuchten versteht man insbesondere das Mitleuchten eines Halbleiterbauelementes durch die ungewollte Lichteinstrahlung eines benachbart angeordneten Halbleiterbauelementes. Dies führt, sowohl bei Anzeigen als auch bei Beleuchtungseinrichtungen, zu einer Verringerung des Kontrasts beziehungsweise einer Aufweichung des Hell-Dunkel-Übergangs einer beleuchteten Fläche.

Eine Verminderung des Nebenleuchtens kann durch eine bauliche Trennung der einzelnen Halbleiterbauelemente bewirkt werden. Alternativ ist es auch möglich, zusätzliche optische Elemente vor den einzelnen Bauelementen anzuordnen, um eine Verbesserung des Kontrasts zu bewirken. Anordnungen, die eine physikalische Trennung der einzelnen Halbleiterbauelemente beziehungsweise eine Anordnung zusätzlicher optischer Elemente erfordern, sind jedoch verhältnismäßig aufwändig in der Herstellung und deshalb mit erhöhten Kosten verbunden.

Eine Aufgabe der vorliegenden Erfindung besteht darin, ein Licht emittierendes Modul der oben genannten Art zu beschreiben, bei der ein Nebenleuchten zumindest vermindert ist. Eine weitere Aufgabe besteht darin, ein Herstellungsverfahren für Licht emittierende Module mit vermindertem Nebenleuchten anzugeben.

Die zugrunde liegende Aufgabe wird durch ein Licht emittierendes Modul der oben genannten Art gelöst, das dadurch gekennzeichnet ist, dass eine Isolationsschicht in einem Bereich der opto-elektronischen Halbleiterbauelemente zwischen dem Trägerelement und der metallischen Anschlussschicht angeordnet ist und die metallische Anschlussschicht eine Blende für die opto-elektronischen Halbleiterbauelemente ausbildet, so dass die elektromagnetische Strahlung nur in einer vorbestimmten Richtung abgestrahlt wird.

Die vorliegende Erfindung ist in Anspruch 1 definiert. In der folgenden Beschreibung bezeichnen die Begriffe "Ausgestaltung" und "Ausführungsbeispiel" nur dann Ausführungsbeispiele der vorliegenden Erfindung, wenn sie jeweils alle im Anspruch 1 definierten Merkmale enthalten. Ansonsten bezeichnen diese Begriffe lediglich andere Beispiele, die für das Verstehen der vorliegenden in Anspruch 1 definierten Erfindung hilfreich sind.

Durch Vorsehung und Ausgestaltung einer metallischen Anschlussschicht auf einer Isolationsschicht über den opto-elektronischen Halbleiterbauelementen kann eine Blendenwirkung mittels der Anschlussschicht erreicht werden. Da die Anschlussschicht in der Regel besonders nahe an dem opto-elektronischen Halbleiterbauelement angeordnet ist, wird eine Verringerung des Nebenleuchtens und eine Verbesserung des Kontrasts des Licht emittierenden Moduls bewirkt. Dabei kann auf zusätzliche, auf dem Licht emittierenden Modul angeordnete Zusatzelemente verzichtet werden.
Gemäß einer vorteilhaften Ausgestaltung ist eine Vertiefung zwischen zwei benachbarten opto-elektronischen Halbleiterbauelementen angeordnet, wobei die Vertiefung durch die metallische Anschlussschicht zumindest teilweise ausgefüllt wird. Durch das Vorsehen und Auffüllen einer Vertiefung zwischen benachbarten opto-elektronischen Halbleiterbauelementen kann ein Nebenleuchten benachbarter Bauelemente verhindert werden. Gemäß einer weiteren vorteilhaften Ausgestaltung weist die metallische Anschlussschicht erste und zweite Bereiche auf, wobei die ersten Bereiche zur Versorgung der opto-elektronischen Bauelemente mit der Betriebsspannung und die zweiten Bereiche zum Formen von Blendenelementen ausgestaltet sind. Durch die Aufteilung der metallischen Anschlussschicht in erste und zweite Bereiche können die spannungsführenden ersten Bereiche verhältnismäßig klein ausgeführt werden, um negative elektrische Effekte wie beispielsweise eine erhöhte Leitungskapazität zu verringern.

Gemäß einer weiteren vorteilhaften Ausgestaltung der Erfindung umfasst die Isolierschicht eine photolumineszente Konversionsschicht, die elektromagnetische Strahlung einer ersten Wellenlänge absorbiert und elektromagnetische Strahlung einer zweiten Wellenlänge emittiert. Durch Vorsehen einer Konversionsschicht in der Isolierschicht kann die Farbtemperatur einer ausgesandten elektromagnetischen Strahlung an die Anforderungen einer spezifischen Anwendung angepasst werden.

Es wird auch ein Herstellungsverfahren für ein Licht emittierendes Modul mit den folgenden Schritten beschrieben:
- Bereitstellen einer Mehrzahl von opto-elektronischen Halbleiterbauelementen,
- Anordnen der Mehrzahl von opto-elektronischen Halbleiterbauelementen auf einem Trägerelement,
- Aufbringen einer Isolationsschicht in einem Bereich der opto-elektronischen Halbleiterbauelemente auf dem Trägerelement,
- Aufbringen einer metallischen Anschlussschicht auf der Isolationsschicht zum Versorgen der opto-elektronischen Halbleiterbauelemente mit einer Versorgungsspannung, wobei in der metallischen Anschlussschicht wenigstens ein Blendenelement ausgebildet ist, das die opto-elektronischen Halbleiterbauelemente zumindest teilweise umschließt.
Durch das Aufbringen einer metallischen Anschlussschicht zum Versorgen der opto-elektronischen Halbleiterbauelemente, die zugleich als Blende für die opto-elektronischen Halbleiterbauelemente wirkt, kann das Herstellungsverfahren für das Licht emittierende Modul vereinfacht werden. Insbesondere werden in einem einzelnen Verfahrensschritt zwei Funktionen, nämlich das Kontaktieren und das Aufbringen von Blenden, bewirkt. Auf das Aufbringen zusätzlicher optischer Elemente kann somit verzichtet werden.

Weitere vorteilhafte Ausgestaltungen der Erfindung sind in den Unteransprüchen angegeben.

Die Erfindung wird nachfolgend an Ausführungsbeispielen anhand der Zeichnungen näher erläutert.

In den Zeichnungen zeigen:
Figur 1 eine schematische Querschnittszeichnung gemäß einer ersten Ausgestaltung,
Figur 2 eine schematische Querschnittszeichnung gemäß einer zweiten Ausgestaltung,
Figur 3 eine Draufsicht gemäß einer dritten Ausgestaltung,
Figur 4 eine Draufsicht gemäß einer vierten Ausgestaltung,
Figur 5 eine Draufsicht gemäß einer fünften Ausgestaltung,
Figur 6 eine erste Anordnung gemäß dem Stand der Technik und
Figur 7 eine zweite Anordnung gemäß dem Stand der Technik.

Bevor die einzelnen Ausgestaltungen der vorliegenden Erfindung beschrieben werden, werden zum besseren Verständnis zunächst Anordnungen bekannter Licht emittierenden Module erläutert.

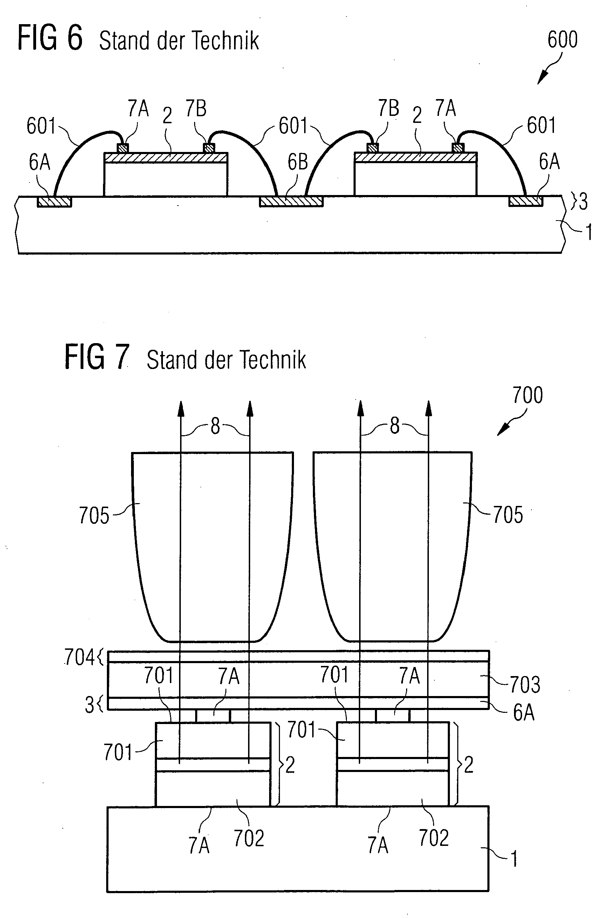

Figur 6 zeigt eine erste Anordnung 600 bei der zwei Halbleiterbauelemente 2, im Ausführungsbeispiel oberflächenemittierende Leuchtdioden (LEDs), auf einem gemeinsamen Trägerelement 1 angeordnet sind. In das Trägerelement 1 ist eine metallische Anschlussschicht 3 in Form von ersten Leiterbahnen 6A und einer zweiten Leiterbahn 6B integriert. Die Leiterbahnen 6A und 6B sind über Bonddrähte 601 mit ersten und zweiten Kontakten 7A und 7B des Halbleiterbauelementes 2 verbunden.

In der ersten Anordnung 600 gemäß der Figur 6 wird ein Nebenleuchten zwischen den Halbleiterbauelementen 2 nicht verhindert. Durch die Verwendung von oberflächenemittierenden Halbleiterbauelementen 2 wird zwar ein Großteil der von den Bauelementen 2 ausgesandten elektromagnetischen Strahlung nach oben beziehungsweise unten ausgestrahlt, so dass eine ungewollte Kopplung nebeneinander angeordneter Bauelemente 2 verhältnismäßig gering ist, eine vollständige Unterdrückung dieses Effektes und des damit einhergehenden Kontrastverlustes ist jedoch nicht möglich. Des Weiteren ist die in der Figur 6 dargestellte erste Anordnung mechanisch relativ anfällig, so dass die einzelnen Halbleiterbauelemente in der Regel in ein Schutzgehäuse eingefasst werden müssen.

Figur 7 zeigt eine verbesserte zweite Anordnung 700 eines Licht emittierenden Moduls. Auf einem Trägerelement 1 sind zwei Halbleiterbauelemente 2 angeordnet. Im Ausführungsbeispiel handelt es sich um Halbleiterchips mit jeweils einem ersten Kontakt 7A an einer Strahlungsauskoppelfläche 701 und einem zweiten Kontakt 7B an einer Grundfläche 702 die mit dem Trägerelement 1 in elektrischer Verbindung steht. Über den Halbleiterbauelementen 2 ist ein Abdeckkörper 703 angeordnet, auf deren Unterseite eine Anschlussschicht 3 in Form einer Leiterbahn 6A angeordnet ist. Die Leiterbahn 6A besteht aus einem transparenten leitfähigen Material und versorgt die Halbleiterbauelemente 2 über den ersten Kontakt 7A mit einer elektrischen Betriebsspannung.

Zusätzlich ist über dem Abdeckkörper 703 eine Schicht 704 mit mindestens einem Lumineszenzkonversionsstoff aufgebracht. Darüber sind optische Elemente 705 vorgesehen, die eine elektromagnetische Strahlung gemäß den Anforderungen einer Anwendung bündeln. Auch in der zweiten Anordnung 700 kann ein Nebenleuchten der einzelnen Halbleiterbauelemente 2 nicht verhindert werden.

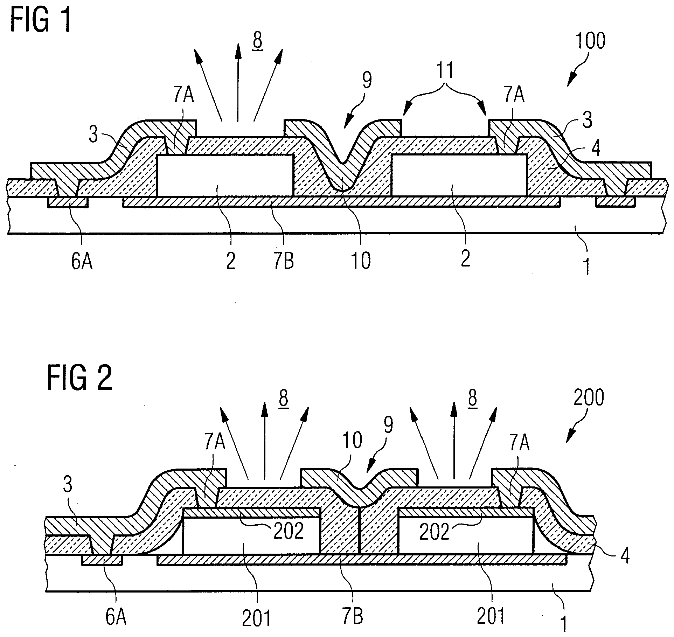

Figur 1 zeigt ein erstes Licht emittierendes Modul 100, bei dem zwei Halbleiterbauelemente 2 auf einem gemeinsamen Trägerelement 1 angeordnet sind. Bei den Halbleiterbauelementen 2 handelt es sich im ersten Ausführungsbeispiel um so genannte Volumenemitter, bei denen elektromagnetische Strahlung 8, insbesondere in Form von Licht, im gesamten Bereich des Halbleiterbauelementes 2 erzeugt wird. Unter elektromagnetischer Strahlung 8 wird im Sinne der Anmeldung auch solche außerhalb des sichtbaren Wellenlängenbereichs bezeichnet, also insbesondere auch infrarote, ultraviolette und Röntgen-Strahlung.

Die Erzeugung von Photonen durch Kombination von Minoritäts- und Majoritätsträgern innerhalb des Halbleiterbauelementes 2 ist zunächst isotrop, das heißt, dass elektromagnetische Strahlung 8 in alle möglichen Raumrichtungen abgestrahlt werden kann. Um die elektromagnetische Strahlung 8 des Licht emittierenden Moduls 100 in einer Abstrahlrichtung zu bündeln, wirkt das Trägerelement 1 als Spiegel. Beispielsweise kann das Trägerelement 1 im Bereich der Halbleiterbauelemente 2 aus einem metallischen Material bestehen.

Auf den Halbleiterbauelementen 2 ist eine Isolationsschicht 4 angeordnet. Darüber ist eine zusätzliche metallische Anschlussschicht 3 angeordnet. Die Isolierschicht 4 ist in einem Bereich, der die Halbleiterbauelemente 2 umgibt, angeordnet und bewirkt im Ausführungsbeispiel eine elektrische Trennung der Anschlussschicht 3 sowohl von dem Trägerelement 1 als auch von den Halbleiterbauelementen 2, insbesondere von deren Seitenflächen. Jedoch ist die Isolierschicht 4 in einem Anschlussbereich unterbrochen, in dem ein elektrischer Kontakt zwischen der Anschlussschicht 3 und einer in das Trägerelement 1 integrierten Leiterbahn 6A besteht.

Sofern der Anschlussschicht 3 eine elektrische Spannung von oben oder anderweitig als über das Trägerelement zugeführt wird, muss die Isolierschicht keine Unterbrechungen aufweisen. Umgekehrt kann die Isolationsschicht an den Rändern der Halbleiterbauelemente 2 unterbrochen werden, wenn eine Zuführung der Betriebsspannung über eine Seitenfläche beabsichtigt ist. Gegebenenfalls kann auf eine Isolierschicht 4 außerhalb der opto-elektronischen Bauelemente 2 auch völlig verzichtet werden, wenn das Trägerelement 1 selbst aus einem nicht leitenden Material, wie etwa Keramik, Kunststoff oder einer unbeschichteten Leiterplatte, besteht.

Über die Anschlussschicht 3 wird ein erster Kontakt 7A zum Versorgen der Halbleiterbauelemente 2 hergestellt. Dabei wirkt die Anschlussschicht 3 zusätzlich als Reflektor, der seitlich von dem Halbleiterbauelement 2 ausgestrahlte elektromagnetische Strahlung 8 zurückwirft. Einen zweiter Kontakt 7B für die Halbeiterbauelemente 2 wird im Ausführungsbeispiel direkt über das Trägerelement 1 bereitgestellt.

In dem in der Figur 1 dargestellten Licht emittierenden Modul 100 wird das linke Halbleiterbauelement 2 von links kontaktiert während das rechte Halbleiterbauelement 2 von rechts kontaktiert wird. Zwischen den zwei Halbleiterbauelementen 2 ist eine Vertiefung 9 angeordnet, die mit einem Blendenelement 10 aufgefüllt ist. Bei dem Blendenelement 10 kann es sich um eine lichtundurchlässige Schicht aus demselben Material, aus dem auch die Anschlussschicht 3 hergestellt ist, oder auch um ein anderes lichtundurchlässiges Material handeln. Die Blendenelemente 10 müssen nicht elektrisch mit den anderen Teilen der Anschlussschicht 3 verbunden sein. Sie können stattdessen auch mit einem Massepotential oder überhaupt keinem definierten elektrisches Potential verbunden sein.

Die Anschlussschicht 3 auf der einen Seite der Halbleiterbauelemente 2 und das Blendenelement 10 auf der jeweils anderen Seite der Halbleiterbauelemente 2 verhindern ein Nebenleuchten benachbarter Halbleiterbauelemente 2. Da die elektromagnetische Strahlung 8 nur nach oben austreten kann, wird die von den Halbleiterelementen 2 erzeugte, zunächst isotrope Strahlung durch Reflexion in eine Raumrichtung gebündelt. Dabei wirken die Anschlussschicht 3 und das Blendenelement 10 zusammen, um eine scharf begrenzte Blendenöffnung 11 zu bilden.

Die Blendenöffnung 11 kann mittels geeigneter optischer Bauelemente auf einer zu beleuchteten Fläche abgebildet werden kann. Dabei ist von Vorteil, dass diese auf Grund der kompakten Bauweise des Licht emittierenden Moduls 100 besonders dicht an den Halbleiterbauelementen 2 angeordnet werden können. Somit ist beispielsweise bei der Verwendung des Licht emittierenden Moduls 100 in einem Kfz-Frontscheinwerfer ein scharfer Hell-Dunkel-Übergang bewirkbar, was zu einer verbesserten Wahrnehmung durch einen Fahrer führt.

Figur 2 zeigt ein zweites Licht emittierendes Modul 200 das in ähnlicher Weise zu dem Licht emittierenden Modul 100 aufgebaut ist. Im Unterschied zu dem Licht emittierenden Modul 100 sind die Halbleiterbauelemente 2 als Oberflächenemitter ausgestaltet. Insbesondere umfassen die Halbleiterbauelemente 2 ein optisch passives Substrat 201 sowie eine optische aktive Schicht 202 in die ein pn-Übergang integriert ist. Eine Erzeugung von elektromagnetischer Strahlung 8 findet nur im Bereich der optisch aktiven Schicht 202 statt. Deshalb kann ein Nebenleuchten der Halbeiterbauelemente 2 in dem Licht emittierenden Modul 200 dadurch erreicht werden, dass ein Blendenelement 10 nur so tief in eine Vertiefung 9 zwischen benachbarten Halbleiterbauelementen 2 eindringt, wie die optisch aktive Schicht 202 dick ist.

Eine Anordnung gemäß der Figur 2 ist besonders bei sehr dicht angeordneten Halbleiterbauelementen 2 oder sehr dünnen Isolationsschichten 4 von Vorteil. Beispielsweise kann die Isolationsschicht 4 aus einer transparenten Kunststofffolie oder Silikon bestehen. In einer vorteilhaften Ausgestaltung ist in die Isolationsschicht eine photolumineszente Konversionsschicht integriert oder auf sie aufgetragen, die die elektromagnetische Strahlung 8 einer ersten Wellelänge oder eines ersten Spektrums, beispielsweise blaues Licht, zumindest teilweise absorbiert und elektromagnetische Strahlung 8 einer zweiten Wellenlänge oder eines zweiten Spektrums, beispielsweise weißes Licht emittiert.

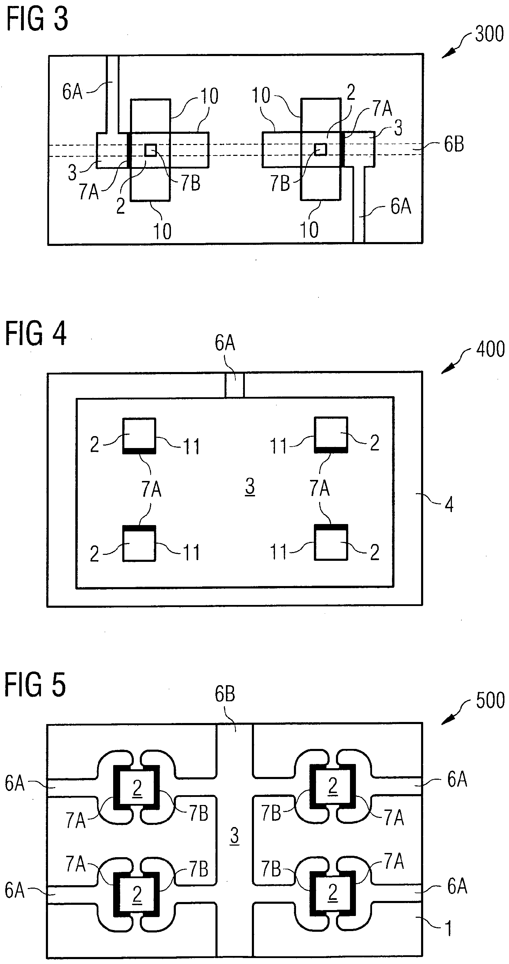

Figur 3 zeigt eine Draufsicht gemäß einer dritten Ausgestaltung eines Licht emittierenden Moduls 300. Auf einem Trägerelement 1 sind zwei Halbleiterbauelemente 2 angeordnet, die über erste Leiterbahnen 6A an der Oberseite des Trägerelementes 1 und eine zweite Leiterbahn 6B an der Unterseite des Trägerelementes 1 mit einer Betriebsspannung versorgt werden. Dazu sind an den ersten Leiterbahnen 6A erste Kontakte 7A ausgebildet, die einen ersten elektrischen Kontakt mit den Halbleiterbauelementen 2 herstellen. Ein zweiter elektrischer Kontakt 7B wird von der Unterseite der Halbleiterbauelemente 2 hergestellt.

Die ersten Leiterbahnen 6A mit den ersten Kontakten 7A sind in einer ersten Anschlussschicht 3 angeordnet, die oberhalb des Trägerelementes 1 angeordnet ist und sich aus dieser erhebt. Dabei begrenzen die ersten Kontakte 7A der Anschlussschicht 3 die Halbleiterbauelemente 2 in einer ersten Raumrichtung. Zusätzliche, ebenfalls erhöhte Blendenelemente 10 sind in den jeweils drei verbleibenden Raumrichtungen der Ebene der Anschlussschicht 3 um die Halbleiterbauelemente 2 herum angeordnet. Die Blendenelemente 10 sind ebenfalls in der Anschlussschicht 3 integriert und können aus demselben oder einem anderen nichttransparenten Material bestehen.

Figur 4 zeigt eine weitere Ausgestaltung eines Licht emittierenden Moduls 400. In der Ausgestaltung der Figur 4 sind vier Halbeiterbauelement 2 in Form eines zweidimensionalen Arrays angeordnet. In der Ausgestaltung gemäß Figur 4 sind die Halbleiterbauelemente 2 komplett durch erhöhte erste Kontakte 7A umschlossen. Die Kontakte 7A stellen einen elektrischen Anschluss zu einer ersten elektrischen Leiterbahn 6A her, über die die Halbleiterbauelemente 2 mit einer elektrischen Betriebsspannung versorgt werden. Auf der Unterseite der Halbleiterbauelemente 2 befinden sich wiederum zweite Kontakte 7B die den Anschluss mit einem Trägerelemente 1 herstellen. Diese sind in der Figur 4 jedoch nicht dargestellt.
Die ersten Kontakte 7A sind in einer Anschlussschicht 3 angeordnet, und wirken zugleich als Blendenelemente 11, die einen seitlichen Strahlungsaustrittaustritt von den Halbleiterbauelementen 2 verhindern. Dabei kann durch die Form einer in die ersten Kontakte 7A integrierten Blendenöffnung 11 der Umriss einer durch das Licht emittierende Modul 400 beleuchtete Fläche bestimmt werden. Die Anschlussschicht 3 ist auf einer Isolierschicht 4 angeordnet, die die Anschlussschicht 3 elektrisch von dem nicht dargestellten Trägerelement 1 trennt.
Figur 5 zeigt eine fünfte Ausgestaltung eines Licht emittierenden Moduls 500 bei dem erste Kontakte 7A und zweite Kontakte 7B in einer Anschlussschicht 3 an der Oberseite von auf einem Trägerelement 1 angeordneten Halbleiterbauelementen 2 ausgebildet sind. Beispielsweise kann es sich bei den Halbleiterbauelementen 2 um Oberflächenemitter handeln, bei denen die Anschlüsse eines pn-Übergangs beide an der Oberfläche der Halbleiterbauelementes 2 angeordnet sind. Die ersten Kontakte 7A und die zweiten Kontakte 7B bilden jeweils die Hälfte einer Halbkugel um die Halbleiterbauelemente 2. Somit ist auch bei den Halbleiterbauelementen 2 des Licht emittierenden Moduls 500 ein Austritt elektromagnetischer Strahlung 8 nur nach oben aus der Betrachtungsebene hinaus möglich. Nach unten hin wirkt ein gemeinsames Trägerelement 1 als Reflektor oder Absorber.

## Patentansprüche

1. Licht emittierendes Modul (100, 200, 300, 400, 500), aufweisend
- ein Trägerelement (1),
- eine Mehrzahl von auf dem Trägerelement (1) angeordneten opto-elektronischen Halbleiterbauelementen (2) zum Erzeugen elektromagnetischer Strahlung (8) und
- eine metallische Anschlussschicht (3), über die die opto-elektronischen Halbleiterbauelemente (2) mit einer Betriebsspannung versorgt werden, wobei die metallische Anschlussschicht (3) eine Blende für die opto-elektronischen Halbleiterbauelemente (2) ausbildet, so dass die elektromagnetische Strahlung (8) nur in einer vorbestimmten Richtung abgestrahlt wird, und
- eine Isolationsschicht (4), die in einem Bereich der opto-elektronischen Halbleiterbauelemente (2) zwischen dem Trägerelement (1) und der metallischen Anschlussschicht (3) angeordnet ist, wobei zwischen den Halbleiterbauelementen (2) eine Vertiefung (9) in der Isolationsschicht (4) angeordnet ist,
**dadurch gekennzeichnet, dass**
die Vertiefung (9) in der Isolationsschicht (4) mit einem Blendenelement (10) aufgefüllt ist, wobei
- das Blendenelement (10) durch eine lichtundurchlässige Schicht gebildet ist, die nicht elektrisch mit der Anschlussschicht (3) verbunden ist.

2. Licht emittierendes Modul (100, 200) nach Anspruch 1,
**dadurch gekennzeichnet, dass**
die metallische Anschlussschicht (3) und das Blendenelement (10) zusammen eine Blendenöffnung (11) ausbilden.

3. Licht emittierendes Modul (100) nach Anspruch 2,
**dadurch gekennzeichnet, dass**
die Vertiefung (9) sich über die gesamte Höhe des opto-elektronischen Halbleiterbauelementes (2) erstreckt.

4. Licht emittierendes Modul (100, 200, 300, 400) nach einem der Ansprüche 1 bis 3, **dadurch gekennzeichnet, dass**
die metallische Anschlussschicht (3) eine erste Anschlussmöglichkeit und das Trägerelement (1) eine zweite Anschlussmöglichkeit zum Versorgen der Mehrzahl von opto-elektronischen Halbleiterbauelementen (2) mit der Betriebsspannung aufweist.

5. Licht emittierendes Modul (100, 200, 300, 400, 500) nach einem der Ansprüche 1 bis 4, **dadurch gekennzeichnet, dass** die opto-elektronischen Halbleiterbauelemente (2) als Lumineszenzdioden, insbesondere als LEDs oder OLEDs ausgebildet sind.

6. Licht emittierendes Modul (200, 500) nach einem der Ansprüche 1 bis 5, **dadurch gekennzeichnet, dass** die opto-elektronischen Halbleiterbauelemente (2) als Oberflächenstrahler ausgebildet sind.

7. Licht emittierendes Modul (400, 500) nach einem der Ansprüche 1 bis 6, **dadurch gekennzeichnet, dass** die Mehrzahl von opto-elektronischen Halbleiterbauelementen (2) in einem Array angeordnet ist.

8. Licht emittierendes Modul (100, 200) nach einem der Ansprüche 1 bis 7, **dadurch gekennzeichnet, dass**
die Isolationsschicht (4) eine photolumineszente Konversionsschicht umfasst, die elektromagnetische Strahlung (8) einer ersten Wellenlänge absorbiert und elektromagnetische Strahlung (8) einer zweiten Wellenlänge emittiert.

## Claims

1. Light-emitting module (100, 200, 300, 400, 500), having
- a supporting element (1),
- a plurality of optoelectronic semiconductor components (2) for the generation of electromagnetic radiation (8) arranged on the supporting element (1) and
- a metallic connecting layer (3) by means of which the optoelectronic semiconductor components (2) are supplied with operating voltage, wherein the metallic connecting layer (3) constitutes a light shade for the optoelectronic semiconductor components (2), as a result of which the electromagnetic radiation (8) is only emitted in a specified direction, and
- an insulation layer (4) arranged in a region of the optoelectronic semiconductor components (2) between the supporting element (1) and the metallic connecting layer (3),
wherein a depression (9) in the insulation layer (4) is located between the optoelectronic semiconductor components (2),
**characterized in that**
the depression (9) in the insulation layer (4) is filled with a light shading element (10), wherein
- the light shading element (10) is formed by an opaque layer which is not electrically connected to the connecting layer (3).

2. Light-emitting module (100, 200) according to claim 1,
**characterized in that**
the metallic connecting layer (3) and the light shading element (10) together form an aperture opening (11).

3. Light-emitting module (100) according to claim 2,
**characterized in that**
the depression (9) extends through the full height of the optoelectronic semiconductor component (2).

4. Light-emitting module (100, 200, 300, 400) according to one of claims 1 to 3, **characterized in that**
the metallic connecting layer (3) incorporates a first connecting facility, and the supporting element (1) a second connecting facility to supply the multiple optoelectronic semiconductor components (2) with operating voltage.

5. Light-emitting module (100, 200, 300, 400, 500) according to one of Claims 1 to 4, **characterized in that** the optoelectronic semiconductor components (2) are formed as luminescent diodes, in particular as LEDs or as OLEDs.

6. Light-emitting module (200, 500) according to one of claims 1 to 5, **characterized in that**
the optoelectronic semiconductor components (2) are implemented as surface emitters.

7. Light-emitting module (400, 500) according to one of claims 1 to 6, **characterized in that**
the plurality of optoelectronic semiconductor components (2) are arranged in an array.

8. Light-emitting module (100, 100) according to one of claims 1 to 7, **characterized in that**
the insulating layer (4) comprises a photoluminescent conversion layer that absorbs electromagnetic radiation (1) at a first wavelength and emits electromagnetic radiation (8) at a second wavelength.

## Revendications

1. Module émetteur de lumière (100, 200, 300, 400, 500), présentant
- un élément porteur (1),
- une pluralité de composants semiconducteurs opto-électroniques (2) disposés sur l'élément porteur (1) en vue de la production de rayonnement
électromagnétique (8) et
- une couche de raccordement métallique (3), par l'intermédiaire de laquelle les composants semiconducteurs opto-électroniques (2) sont alimentés d'une tension de service, sachant que la couche de raccordement métallique (3) constitue un diaphragme pour les composants semiconducteurs opto-électroniques (2) de sorte que le rayonnement électromagnétique (8) est rayonné uniquement dans une direction prédéterminée, et
- une couche d'isolation (4), qui est disposée dans une zone des composants semiconducteurs opto-électroniques (2) entre l'élément porteur (1) et la couche de raccordement métallique (3),
sachant que,
entre les composants semiconducteurs (2) est disposé un creusement (9) dans la couche d'isolation (4),
**caractérisé en ce que**
le creusement (9) dans la couche d'isolation (4) est rempli d'un élément de diaphragme (10), sachant que l'élément de diaphragme (10) est constitué par une couche opaque, qui n'est pas connectée électriquement avec la couche de raccordement (3).

2. Module émetteur de lumière (100, 200) selon la revendication 1,
**caractérisé en ce que**
la couche de raccordement métallique (3) et l'élément de diaphragme (10) constituent ensemble une ouverture du diaphragme (11).

3. Module émetteur de lumière (100) selon la revendication 2,
**caractérisé en ce que**
le creusement (9) s'étend sur la hauteur complète du composant semiconducteur opto-électronique (2).

4. Module émetteur de lumière (100, 200, 300, 400) selon une quelconque des revendications 1 à 3,
**caractérisé en ce que**
la couche de raccordement métallique (3) présente une première possibilité de raccordement et l'élément porteur (1) une seconde possibilité de raccordement en vue de l'approvisionnement de la pluralité des composants semiconducteurs opto-électroniques (2) en tension de service.

5. Module émetteur de lumière (100, 200, 300, 400, 500) selon une quelconque des revendications 1 à 4,
**caractérisé en ce que**
les composants semiconducteurs opto-électroniques (2) sont constitués comme diodes luminescentes, notamment comme LED ou comme OLED.

6. Module émetteur de lumière (200, 500) selon une quelconque des revendications 1 à 5,
**caractérisé en ce que**
les composants semiconducteurs opto-électroniques (2) sont constitués comme projecteurs de surface.

7. Module émetteur de lumière (400, 500) selon une quelconque des revendications 1 à 6,
**caractérisé en ce que**
la pluralité des composants semiconducteurs opto-électroniques (2) est disposée en un éventail.

8. Module émetteur de lumière (100, 200) selon une quelconque des revendications 1 à 7,
**caractérisé en ce que**
la couche d'isolation (4) comporte une couche de conversion photo-luminescente, qui absorbe du rayonnement électromagnétique (8) d'une première longueur d'ondes et émet du rayonnement électromagnétique (8) d'une seconde longueur d'ondes.
